# FASCICULE DE BREVET EUROPEEN

(11) **EP 1 311 062 B1**
(45) Date de publication et mention de la délivrance du brevet: **30.07.2008**
(21) Numéro de dépôt: 02292777.6
(22) Date de dépôt: 07.11.2002
(51) Int. Cl.: H03G 3/30

(54) **Procédé d'optimisation du rendement d'un amplificateur destiné à amplifier simultanement plusieurs porteuses modulées**
Verfahren zur Optimierung des Wirkungsgrads eines Verstärkers für Mehrträgersignale
Method for optimising the efficiency of an amplifier for multicarrier signals

(30) Priorité: 12.11.2001 FR 0114603
(43) Date de publication de la demande: 14.05.2003
(73) Titulaire: Alcatel Lucent, 75008 Paris (FR)
(72) Inventeur: Dartois, Luc, 78955 Carrières sous Poissy (FR)
(74) Mandataire: El Manouni, Josiane

(56) Documents cités:
- US-A- 6 154 659
- US-B1- 6 236 864

## Description

L'invention est relative à un procédé de transmission de signaux de télécommunication à l'aide d'un amplificateur de puissance destiné à amplifier simultanément plusieurs signaux modulant des porteuses différentes. Elle concerne plus particulièrement un procédé de ce type dans lequel on prévoit, pour optimiser le rendement de l'amplificateur, en amont de ce dernier, un écrêtage du signal de composition des signaux modulant plusieurs porteuses.

L'invention se rapporte aussi à l'application d'un tel procédé à un émetteur radio, une station de base d'un système de télécommunication comprenant un émetteur radio, et à un réseau de téléphonie mobile comprenant des émetteurs radio.

Les amplificateurs sont des composants électroniques qui présentent en général un comportement non-linéaire, c'est-à-dire qui sont tels que le signal de sortie est souvent déformé par rapport au signal d'entrée. C'est pourquoi dans les systèmes de télécommunication, il est prévu des moyens pour linéariser les amplificateurs. Le procédé le plus courant consiste à appliquer une pré-distorsion aux signaux avant l'entrée de l'amplificateur, cette pré-distorsion étant telle qu'elle permet de fournir à la sortie de l'amplificateur un signal qui représente de façon fidèle le signal d'entrée avant pré-distorsion. La pré-distorsion peut être de type numérique ou analogique.

Un autre procédé connu de linéarisation des amplificateurs consiste à comparer le signal en entrée de l'amplificateur au signal à sa sortie, la comparaison fournissant un signal d'erreur qui est combiné, en opposition de phase, au signal de sortie afin qu'après cette combinaison le signal soit une représentation fidèle du signal d'entrée.

Par ailleurs, un amplificateur utilisé dans une chaîne d'émission doit présenter un rendement le plus élevé possible pour limiter la consommation et les dimensions de cet amplificateur. Le rendement est le rapport entre la puissance du signal de sortie et la puissance totale consommée par l'amplificateur.

Mais un rendement élevé n'est pas compatible avec une forte dynamique du signal d'entrée. En effet, les signaux de sortie présentent une valeur limite ou valeur de saturation. Quelle que soit la valeur du signal d'entrée, le signal de sortie ne peut dépasser cette valeur limite. On comprend donc aisément que le rendement diminue quand les signaux d'entrée dépassent la valeur au-delà de laquelle l'amplificateur sature. En outre, l'amplificateur présente un comportement linéaire, à gain constant, pour les signaux d'entrée les plus faibles, et un comportement non-linéaire quand les signaux de sortie augmentent en se rapprochant de la saturation, le gain diminuant au fur et à mesure que la puissance de sortie augmente. Un amplificateur est ainsi, en général, dimensionné de façon telle que la puissance de saturation corresponde à la crête (ou pic) maximale ou pic du signal de sortie et que la puissance moyenne de sortie se trouve dans la zone de linéarité de l'amplificateur. Le rapport, qui s'exprime en dB, entre la puissance de saturation de l'amplificateur et sa puissance moyenne d'utilisation constitue une marge de puissance, ou "backoff", pour cet amplificateur. On choisit habituellement un amplificateur ayant une marge de puissance, en dB, égale au rapport de la puissance de crête du signal d'entrée sur la valeur moyenne de la puissance du signal d'entrée. Ce rapport est en général dénommé PAR (Peak to Average Ratio). Plus le PAR est élevé et plus le rendement de l'amplificateur est faible.

Il est connu d'augmenter le rendement des amplificateurs, en appliquant un procédé d'écrêtage (ou "clipping" en langue anglaise) qui consiste à limiter l'amplitude des signaux à l'entrée de l'amplificateur à une valeur maximale. La valeur limite (ou seuil), ou rayon d'écrêtage, est déterminée en fonction de la situation la plus défavorable ("pire cas") des signaux à transmettre par la chaîne d'émission dont fait partie l'amplificateur, c'est-à-dire en fonction du plus grand rapport possible entre la puissance de crête et la puissance moyenne de ce signal.

Cette valeur limite doit être choisie de façon précise pour minimiser les effets perturbateurs induits sur la qualité du signal en entrée de l'amplificateur. En effet, comme toute non linéarité, cet écrêtage entraîne, en plus d'une atténuation, une distorsion du signal. Par ailleurs la forme de l'écrêtage doit aussi être contrôlée spectralement afin de ne pas perturber le gabarit spectral du signal à amplifier. Le gabarit spectral doit rester meilleur (de préférence d'un ordre de grandeur) que le gabarit obtenu avec les défauts résiduels de l'amplificateur linéarisé.

Les défauts de distorsion et d'atténuation doivent en outre respecter les contraintes de qualité et de fidélidité de la chaîne de transmission souvent définies par la norme radio correspondante. Par exemple dans la norme UMTS ces contraintes sont définies par les recommandations 3GPP TS25-104 et TS 25-141.

En général, les paramètres de pré-distorsion, la polarisation, la tension et le dimensionnement de l'amplificateur de puissance sont choisis pour obtenir un rendement maximal pour une puissance d'émission maximale. Ainsi, pour des faibles puissances, l'efficacité n'est pas optimale. En effet, à faible puissance, le rendement de l'amplificateur est faible parce que sa consommation statique (due au courant de polarisation) est prépondérante par rapport à la puissance dynamique servant à amplifier le signal.

Le problème de rendement de l'amplificateur d'émission est un problème important à résoudre pour la future norme d'émission UMTS qui utilisera des codes orthogonaux pour différencier des communications transmises simultanément, c'est-à-dire la technique CDMA ("Code Division Multiple Access"). En effet, il est prévu que les stations de base seront destinées à transmettre simultanément plusieurs (au maximum 4) bandes de fréquences adjacentes. Dans ce cas, le PAR "naturel" a une valeur élevée (jusqu'à 12dB) car il correspond au cumul du PAR lié à la superposition des differents utilisateurs (codes) de chaque porteuse et du PAR lié à la superposition des différentes porteuses.

En outre, dans le cadre de la norme UMTS, il est exigé que la puissance d'émission présente une précision d'au moins 0,25 dB environ pour les informations de trafic (c'est-à-dire les données). Cette précision est incompatible avec l'utilisation d'un procédé d'écrêtage important et non contrôlé car ce dernier peut faire varier la précision sur la puissance d'émission jusqu'à 1 dB.

L'invention remédie à ces inconvénients.

Le procédé selon l'invention est caractérisé en ce qu'on fait dépendre le seuil d'écrêtage du signal composite - correspondant à plusieurs porteuses modulées transmises par un même amplificateur de puissance - de la somme des puissances de toutes les porteuses modulées transmises et en ce qu'on adapte les paramètres de fonctionnement de l'amplificateur à cette somme des puissances afin d'optimiser le rendement de l'amplificateur.

Dans ces conditions les caractéristiques de l'amplificateur peuvent être adaptées en temps réel aux caractéristiques du signal d'entrée pour obtenir en permanence un rendement optimal.

En variante, au lieu de faire varier directement le rayon ou seuil d'écrêtage, on prévoit d'associer, d'une part, un amplificateur à gain variable à un élément fournissant un rayon d'écrêtage fixe, le gain variable de cet amplificateur dépendant de la somme des puissances de toutes les porteuses modulées, et, d'autre part, un atténuateur pour restituer la puissance d'émission voulue à l'entrée de l'amplificateur linéarisé.

Quel que soit le mode de réalisation, la variation du gain d'écrêtage permet une meilleure précision sur la puissance d'émission.

L'invention concerne, de façon générale, un procédé de transmission de signaux de télécommunication à l'aide d'un amplificateur de puissance destiné à amplifier simultanément plusieurs porteuses modulées différentes, un écrêtage du signal de composition des porteuses étant prévu en amont de l'amplificateur, ce dernier étant associé à des moyens de linéarisation, ce procédé étant caractérisé en ce qu'on fait dépendre le seuil d'écrêtage de la somme des puissances de toutes les porteuses modulées transmises et en ce qu'on fait dépendre au moins un paramètre de fonctionnement de l'amplificateur de cette somme de puissances afin de maintenir un rendement optimum de l'amplificateur et/ou afin de minimiser la marge de puissance, c'est-à-dire l'écart entre la puissance de saturation et la puissance moyenne d'utilisation.

Le paramètre de fonctionnement de l'amplificateur est par exemple choisi dans le groupe comprenant la tension d'alimentation et l'intensité de polarisation.

Dans une réalisation, le seuil d'écrêtage est déterminé par un élément à gain variable associé à un élément fournissant un rayon d'écrêtage constant.

Selon une réalisation, on compense la modification de gain provoquée par la modification du rayon d'écrêtage par une modification de gain en sens inverse de façon que le produit des deux gains soit sensiblement égal à 1.

De préférence, on fait varier les paramètres de fonctionnement de l'amplificateur à un rythme suffisamment bas pour permettre la mise à jour des paramètres de linéarisation de l'amplificateur.

Dans une réalisation, on fixe le point de fonctionnement de l'amplificateur de façon telle que sa puissance maximale admissible soit légèrement plus élevée que la puissance nécessaire afin de permettre une transmission de puissance supplémentaire demandée rapidement.

La marge de puissance supplémentaire de l'amplificateur est par exemple de l'ordre de 10 %.

Les signaux sont par exemple transmis en mode CDMA ; dans ce cas, pour chaque porteuse, la puissance est évaluée sur la durée d'au moins un symbole pendant chaque intervalle de temps.

Le symbole utilisé pour l'estimation est de préférence le symbole le plus long de l'intervalle de temps. L'estimation est, dans un exemple, effectuée au rythme des bits de codage.

De préférence, les porteuses se trouvent dans des bandes adjacentes.

L'invention concerne aussi l'application de ce procédé à une station de base d'un système de télécommunication.

Elle peut aussi s'appliquer à un terminal de système de télécommunication.

D'autres caractéristiques et avantages de l'invention apparaîtront avec la description de certains de ses modes de réalisation, celle-ci étant effectuée en se référant aux dessins ci-annexés sur lesquels :
la figure 1 est un diagramme illustrant sur un exemple le procédé conforme à l'invention,
la figure la est un diagramme analogue à celui de la figure 1 pour une variante, et
la figure 2 est un schéma d'une station de base faisant appel au procédé conforme à l'invention.

Dans l'exemple qui va être décrit ci-après, on se réfère à un système de télécommunication de type UMTS dans lequel les stations de base émettent des signaux de type CDMA vers les terminaux.

On rappelle brièvement le principe de transmission CDMA : les signaux sont transmis sous forme de symboles et chaque symbole comprend un certain nombre (4 à 128 ou 256) d'échantillons (« chips » en langue anglaise) représentant un code. Une station de base émet simultanément vers une pluralité de terminaux. L'ensemble des terminaux reçoit tous les signaux émis par la station de base, mais comme à chaque terminal est affecté un code déterminé, différent des autres, et comme les codes sont orthogonaux, ce terminal pourra isoler efficacement les signaux selon le code déterminé qui lui est affecté.

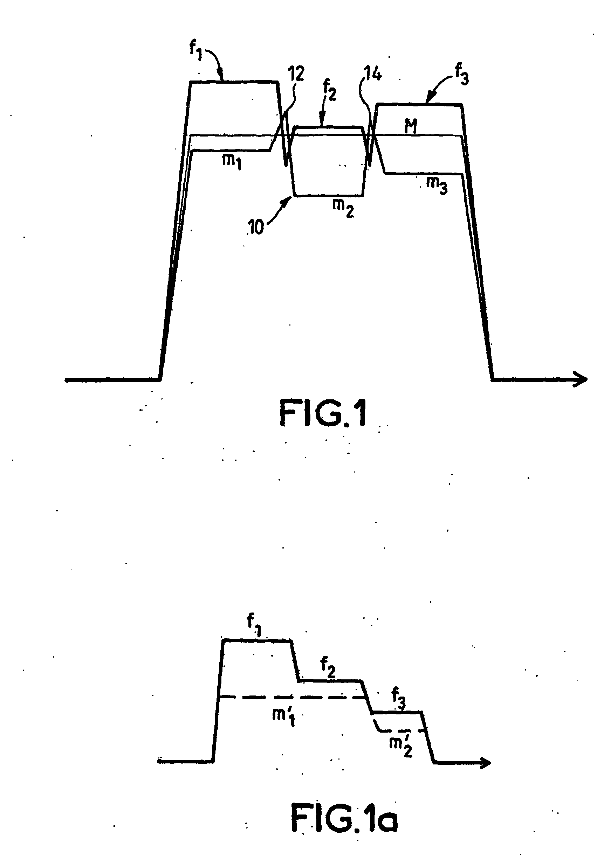

Dans ce système de télécommunication UMTS on prévoit une pluralité de porteuses ayant chacune une largeur de bande 5 mégahertz. Pour des raisons d'économie, on transmet à l'aide d'un seul amplificateur l'ensemble des porteuses modulées de la station de base. Dans l'exemple représenté sur la figure 1 on prévoit trois bandes porteuses adjacentes f1, f2, f3.

Les puissances affectées à chacune de ces porteuses peuvent être sensiblement différentes. Ainsi, dans cet exemple, la porteuse f1 présente la puissance la plus élevée et la porteuse f2 la puissance la plus faible. Chacune de ces porteuses correspond à une bande de fréquences de largeur 5 MHz.

On rappelle que, selon l'état antérieur de la technique, dans une telle situation, on utilise une densité statistique moyenne de puissance écrêtée qui est constante pour les trois bandes f1, f2, f3, c'est-à-dire qu'on utilise un filtre qui limite les amplitudes des signaux dans les bandes f1, f2 et f3 à une même valeur M.

Cette densité M étant la même pour les trois bandes et celles-ci présentant des amplitudes différentes, les rapports signal à bruit sont donc différents. On voit ainsi que le rapport signal à bruit est nettement plus important pour la porteuse f1 que pour la porteuse f2.

Selon un premier aspect de l'invention, on prévoit un écrêtage qui, pour chaque porteuse, est fonction de sa puissance. Ainsi, dans l'exemple représenté sur la figure 1, la densité statistique moyenne de puissance écrêtée m₁ pour la porteuse f1 est la plus élevée et la densité correspondante m₂ pour la porteuse f2 est la plus faible. En d'autres termes, pour l'écrêtage, on choisit un gabarit de filtre 10 qui correspond à celui du signal d'entrée f1, f2, f3. Les distorsions sont ainsi minimisées pour les porteuses les plus faibles et comme la densité statistique moyenne de puissance écrêtée varie avec le signal d'entrée, cette densité peut être optimisée à chaque instant. On voit sur la figure 1 que la densité m₁ la plus élevée est inférieure à la densité M de l'état antérieur de la technique. L'optimisation la densité statistique moyenne de puissance écrêtée permet un dimensionnement moins sévère de l'amplificateur.

Selon un autre aspect de l'invention, qui peut s'utiliser indépendamment du premier aspect, le rayon d'écrêtage moyen varie avec la puissance totale du signal d'entrée et la marge de puissance (c'est-à-dire l'écart, en dB, entre la puissance de saturation et la puissance d'utilisation moyenne) de l'amplificateur varie avec la puissance totale du signal.

Dans une réalisation simplifiée correspondant à un exemple où l'amplificateur transmet trois ou quatre bandes porteuses, on détecte la porteuse ayant la puissance la plus faible et on affecte à cette porteuse un filtre fournissant la densité de puissance d'écrêtage la plus faible tandis qu'on affecte la même densité de puissance aux deux (ou trois) autres bandes porteuses. Dans ce cas, le filtrage adaptatif ne nécessite le choix qu'entre un nombre limité de filtres. En outre, les résultats obtenus avec cette réalisation sont sensiblement les mêmes que ceux obtenus lorsque le filtre d'écrêtage reflète exactement les signaux d'entrée.

Cet exemple de filtrage est représenté sur la figure 1a où l'on voit que le gabarit de filtrage comporte deux densités de puissance d'écrêtage m'₁ et m'₂, m'₁ étant affecté aux porteuses f1 et f2, et m'₂ étant affecté à la porteuse f3 d'amplitude la plus faible.

Selon encore un autre aspect de l'invention, on utilise les zones de garde entre les bandes de fréquences porteuses f1, f2 et f3 pour rejeter dans ces zones les distorsions résiduelles qui pourraient se trouver dans la bande utile et qui contribueront donc faiblement à la distorsion des porteuses. On voit ainsi sur la figure 1 qu'entre les densités de puissance d'écrêtage m₁ et m₂, le filtre présente une atténuation moins importante 12, et de même entre les bandes f2 et f3, le filtre présente également une atténuation 14 moins importante.

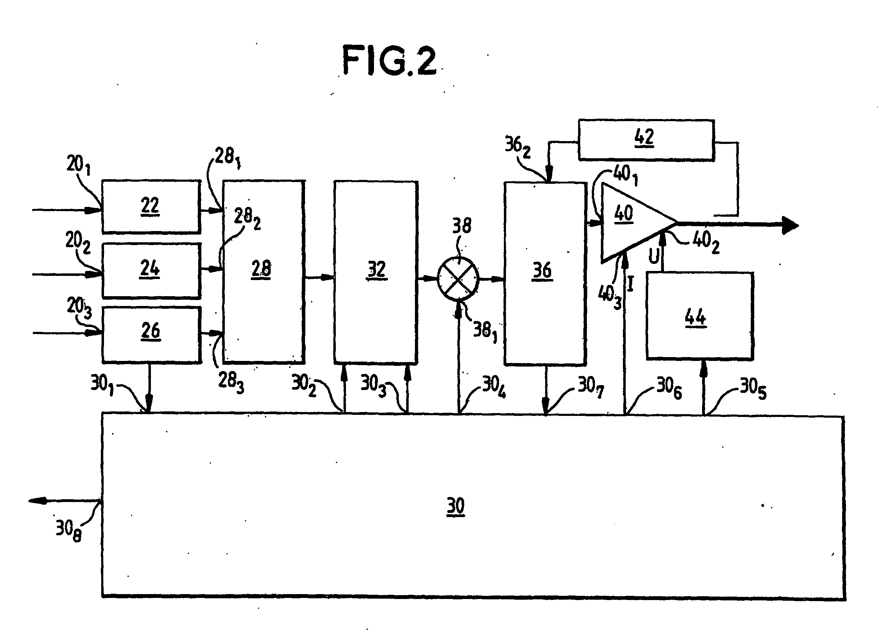

La figure 2 représente, sous forme de blocs, une station de base faisant appel au procédé selon l'invention.

Cette station de base est, comme dans l'exemple de la figure 1, destinée à émettre trois bandes de fréquence adjacentes f1, f2 et f3. Les porteuses modulées f1, f2 et f3, c'est-à-dire les symboles auxquels sont affectés des codes, sont appliquées aux entrées respectivement 20₁, 20₂ et 20_{3,} de dispositifs respectivement 22, 24 et 26 d'estimation de puissance et de transmission.

Le dispositif 22 transmet le signal f1 d'entrée à une première entrée 28₁ d'un dispositif 28 de synthèse ou composition de signaux se trouvant sur des porteuses différentes. De même, la sortie du dispositif 24 est connectée à la seconde entrée 28₂ du dispositif 28 et la sortie du dispositif 26 est reliée à la troisième entrée 28₃ du dispositif 28.

Les estimations de puissances fournies par les dispositifs 22, 24 et 26 sont appliquées sur une entrée 30₁ d'un microprocesseur 30.

Le dispositif 28 fournit sur sa sortie 28₄ un signal composite qui est appliqué à l'entrée d'un organe d'écrêtage 32 qui effectue le filtrage 10 représenté sur la figure 1. Les données permettant ce filtrage sont fournies par deux sorties 30₂ et 30₃ du microprocesseur. La sortie 30₂ détermine le seuil d'écrêtage du signal composite à partir de la somme des puissances P1, P2 et P3 de chacune des porteuses f1, f2 et f3, c'est-à-dire à partir du signal appliqué sur l'entrée 30₁ de ce microprocesseur 30.

La sortie 30₃ fournit le gabarit de filtrage 10. Celui-ci respecte la proportionnalité entre porteuses de façon à maintenir une distorsion similaire sur chaque porteuse ; on obtient en quelque sorte un filtre adapté.

La sortie de l'organe 32 est reliée à l'entrée d'un organe 36 de pré-distorsion numérique par l'intermédiaire d'un élément 38 à gain variable. L'élément 38 à gain variable comporte une entrée de commande 38₁ du gain d'écrêtage qui est reliée à une sortie 30₄ du microprocesseur 30. Le signal délivré par la sortie 30₄ commande le gain en fonction de la puissance totale, c'est-à-dire de la somme des puissances P1, P2 et P3 et du rayon d'écrêtage. Ce gain est tel que l'amplitude du signal en sortie de l'élément 38 est pratiquement égale à l'amplitude du signal à l'entrée de l'organe 32. Ce gain est une fonction relativement simple qui peut être tabulée.

La sortie de l'organe 36 de pré-distorsion numérique est reliée à l'entrée 40₁ de l'amplificateur de puissance 40 à linéariser. L'organe 36 comporte une seconde entrée 36₂ qui, de façon classique (pour une prédistorsion numérique adaptative à apprentissage par un récepteur de mesure), reçoit, par un élément de mesure 42, des données provenant de la sortie de l'amplificateur 40 afin de permettre la mise à jour des tables de pré-distorsion.

L'amplificateur 40 comporte deux entrées d'alimentation 40₂ et 40₃, dont la première, 40₂, est reliée à la sortie d'une alimentation 44 qui fournit une tension déterminée par une sortie 30₅ du microprocesseur 30. La seconde entrée 40₃ reçoit un signal de commande d'une sortie 30₆ du microprocesseur 30, ce signal déterminant l'intensité de polarisation des grilles des transistors. Les signaux de commande appliqués sur les entrées 40₃ et 40₂ dépendent tous les deux de la puissance totale P1 + P2 + P3.

Dans l'exemple les coefficients de prédistorsion sont calculés et mis à jour dans l'organe 36 par comparaison entre le signal de sortie de l'organe 38 et le signal sur l'entrée 36₂ provenant du récepteur 42. L'organe 36 comporte une sortie connectée à une entrée 30₇ du microprocesseur. Ce dernier contrôle ainsi l'état de convergence des tables de prédistorsion. Cet état conditionne la vitesse de changement du point de fonctionnement de l'amplificateur 40 par les commandes 30₅ et 30₆ comme décrit plus loin.

Enfin, le microprocesseur 30 comporte une sortie 30₈ fournissant au système de télécommunication une indication sur la puissance que peut encore admettre l'amplificateur 40. Cette puissance admissible instantanée est liée (comme expliqué plus loin) à la différence entre le point courant de saturation de l'amplificateur et le rayon d'écrêtage courant. Elle correspond en totalité ou partiellement à une marge sur le point de saturation de l'amplificateur par rapport à la puissance courante.

Le fonctionnement est le suivant :

Les organes 22, 24 et 26 effectuent une estimation de puissance sur chacune des porteuses f1, f2 et f3. A cet effet, les organes 22, 24 et 26 somment les puissances des échantillons successifs (bits élémentaires) sur au moins un symbole, de préférence le plus long, soit sur 256 échantillons, et sur une durée inférieure à un intervalle de temps. Dans le cas de la norme UMTS, la fréquence d'apparition des bits élémentaires (c'est-à-dire la fréquence d'échantillonnage choisie dans l'exemple) est de 3,84 MHz. Cette estimation est donc effectuée pour chaque intervalle de temps sur un horizon de 33 à 666µs et est répétée tous les intervalles de 666µs.

Grâce à la sélection d'un symbole dans chaque intervalle de temps, on peut détecter de façon rapide les variations de puissance sur chaque porteuse.

A partir des puissances P1, P2 et P3 estimées à chaque intervalle de temps ("time slot" en langue anglaise), le microprocesseur 30 détermine, d'une part, le rayon d'écrêtage et, d'autre part, le gabarit de filtrage 10 (figure 1) pour les trois porteuses considérées. On peut également utiliser le procédé simplifié représenté sur la figure 1a.

Dans un exemple, le microprocesseur 30 contient en mémoire un ensemble de filtres et le choix des filtres est effectué en fonction de tables prédéterminées. Ces tables pré-établies sont déterminées soit par calculs, soit de façon empirique.

L'expérience montre qu'avec trois ou, au maximum, quatre, porteuses, le nombre de filtres à mémoriser pour, par exemple, un contraste maximum de 18 dB entre les puissances des porteuses, le nombre de filtres à stocker est limité. Ainsi, pour trois porteuses, environ 10 filtres peuvent être suffisants, chaque filtre ayant un maximum de 32 à 256 coefficients complexes dans le cas de filtres à réponse impulsionnelle finie.

Le rayon ou seuil d'écrêtage, qui est calculé à chaque intervalle de temps en se basant sur la somme des puissances des porteuses P1, P2 et P3, a par exemple, une valeur d'environ + 4 dB au-dessus de la puissance totale dans le cas où l'on prévoit trois porteuses UMTS.

Les commandes appliquées sur les entrées 40₂ et 40₃ de l'amplificateur 40 permettent de régler les caractéristiques de cet amplificateur de façon que son rendement conserve une valeur élevée. Dans l'exemple, le microprocesseur 30 contient en mémoire des tables qui permettent de régler l'intensité I du courant i appliqué sur l'entrée 40₃ et la tension U appliquée sur l'entrée 40₂ de façon telle que le point de compression à 1 dB reste proche du cercle d'écrêtage, afin de conserver une efficacité et une convergence correctes de la prédistorsion, en même temps qu'un rendement correct. On rappelle que comme tout système bouclé ou adaptatif, la convergence est l'état stable où, après un certain nombre d'itérations (temps de convergence), les valeurs de la table de prédistorsion ne se modifient plus (au bruit de la boucle près) et donnent la meilleure représentation de la fonction de transfert inverse de l'amplificateur et, de ce fait, minimise la différence spectrale entre signal d'entrée et signal de sortie de l'amplificateur linéarisé.

On rappelle aussi que le point de compression à 1 dB est le point de fonctionnement des signaux forts (aux environs du rayon d'écrêtage) pour lesquels le gain est inférieur de 1 dB au gain de la partie linéaire.

Les constantes de temps des divers organes de la station représentée sur la figure 2 n'ont pas toutes la même valeur. Ainsi : les estimations de puissance dans les dispositifs 22 à 26 ont des constantes de temps de l'ordre de la microseconde à la centaine de µs, les constantes de temps de l'organe 36 de pré-distorsion numérique sont de l'ordre du dixième de milliseconde à quelques millisecondes, tandis que les constantes de temps de réglage des paramètres I et U sont de 1 milliseconde à la seconde, voire davantage c'est-à-dire la minute. En effet, ces paramètres I et U ne peuvent varier trop rapidement car il est nécessaire qu'ils permettent l'adaptation des coefficients de pré-distorsion. Autrement dit, le taux de variation des paramètres I et U doit être suffisamment faible pour permettre le calcul de mise à jour des tables de pré-distorsion.

Dans un mode de réalisation préféré, la commande de tension de l'amplificateur présente une hystérésis telle que la diminution de tension soit plus lente que l'augmentation afin que, lors d'une augmentation rapide de puissance de l'une des porteuses, l'amplificateur puisse conserver une marge de puissance suffisante tout en conservant des tables de pré-distorsion valables.

Autrement dit, ce comportement d'hystérésis doit être tel qu'il soit possible d'absorber des abonnés supplémentaires avant d'avoir remonté le point de fonctionnement sans perturbation. Ainsi, le point de saturation de l'amplificateur doit être tel que le rayon d'écrêtage correspondant puisse s'adapter à une demande de puissance supplémentaire pour quelques abonnés.

Par exemple, dans le cas d'un amplificateur de puissance pouvant transmettre 30 watts (c'est-à-dire trois porteuses de 10 watts) la marge peut être de l'ordre de 2 watts. Ainsi, avant augmentation de la tension U de l'amplificateur, ce dernier bénéficie d'une marge de 2 watts utilisable pour absorber des demandes supplémentaires. Ainsi, quel que soit le rayon d'écrêtage instantané, la polarisation de l'amplificateur sera toujours effective 2 watts plus haut, soit, dans l'exemple, dès 28 Watts atteint le maximum et on ne descend jamais en dessous de 4 watts même si aucune communication n'est active (2watts de marge et environs 2 watts pour l'émission des canaux communs de chaque porteuse ou cellule). Le rendement moyen sur une journée garde une valeur importante car la puissance moyenne aux heures creuses peut être 10 fois inférieure à la puissance moyenne aux heures pleines.

Pour permettre le couplage de la convergence des signaux de prédistorsion numérique avec l'adaptation des caractéristiques de l'amplificateur, il est nécessaire d'utiliser des algorithmes rapides pour la prédistorsion numérique, avec des temps de convergence de 100 microsecondes à quelques millisecondes. On fera par exemple appel à des algorithmes de type LMS (Least Mean Square), c'est à dire des algorithmes utilisant la méthode des moindres carrés.

On peut aussi faire appel à un rebouclage dans le domaine temporel (par opposition au domaine fréquentiel). A ce sujet on rappelle que les procédés de prédistorsions numériques adaptatives les plus récents peuvent faire l'apprentissage et la mise à jour des tables de deux façons différentes :
- Soit en comparant en temps réel, au moyen d'un récepteur large bande, chaque échantillon de signal émis par l'amplificateur à chaque échantillon qu'on veut émettre (sur la sortie de l'organe 38) : c'est ce rebouclage dans le domaine temporel qui est utilisé dans l'exemple du fait de sa rapidité.
- Soit en comparant le spectre du signal de sortie de l'organe 38 avec le spectre émis, ce dernier étant périodiquement analysé par sous bande au moyen d'un récepteur à bande étroite qui balaie la bande d'émission. Ce rebouclage dans le domaine fréquentiel converge plus lentement mais est moins coûteux.

La puissance de traitement nécessaire pour le microprocesseur 30 est relativement faible quand on fait appel à des paramètres d'adaptation qui sont pré-calculés ou pré-déterminés sous forme de tableaux.

Dans le cas de l'application de la norme UMTS de téléphonie mobile, la précision du contrôle de puissance est maintenue pour toutes les porteuses (au maximum quatre porteuses selon les schémas d'attribution des licences) tandis que le signal composite présente un rapport puissance de crête sur puissance moyenne de 4 dB pour trois porteuses et le rendement peut excéder de 15 % la puissance de sortie maximale alors que ce rendement est de 5 à 8% pour les stations de base classiques.

En outre, grâce aux filtres adaptatifs d'écrêtage, il est possible, sans compromettre le fonctionnement optimal de la station, de supporter un contraste important entre les porteuses. Ainsi, une porteuse peut être complètement "chargée" et une autre porteuse non chargée, c'est-à-dire ne transmet que des signaux de signalisation. Il est également possible d'utiliser un même amplificateur pour deux cellules concentriques, c'est-à-dire une cellule ayant une couverture relativement étendue et une autre cellule de rayon nettement plus faible, mais de trafic important.

Par ailleurs, la variation de tension U d'alimentation de l'amplificateur, ainsi que la variation de marge de puissance pour permettre d'adapter ces paramètres à l'utilisation, peut réduire d'un facteur 2 environ la consommation d'énergie. Cette adaptation permet aussi d'améliorer la fiabilité de l'amplificateur et donc de la station de base utilisant cet amplificateur de puissance.

La marge de puissance calculée peut être utilisée pour les algorithmes de contrôle de puissance émise. En effet, quand on fait appel à la technique CDMA (et donc en UMTS), il est indispensable, pour obtenir une capacité suffisante, de minimiser les interférences induites dans la cellule et vers les autres cellules. Pour cela, il faut, à chaque intervalles de temps (666µs), redéfinir de façon contrôlée et précise, la puissance d'émission de et vers chaque abonné (code) afin de n'émettre que le strict nécessaire de puissance à mieux que 1 dB, ou même 0.5 dB, près en fonction de la qualité de service négociée avec le mobile.

Bien que dans ce qui précède on ait décrit l'utilisation de l'invention dans le cadre d'une transmission de type CDMA, l'invention n'est pas limitée à cette application. Elle peut également être utilisée à une transmission TDMA sur plusieurs porteuses.

L'invention s'applique principalement à une station de base d'un système de télécommunication. Cependant, elle peut aussi s'appliquer à un terminal devant émettre simultanément sur plusieurs porteuses.

## Revendications

1. Procédé de transmission de signaux de télécommunication à l'aide d'un amplificateur de puissance destiné à amplifier simultanément plusieurs porteuses modulées différentes (f1, f2, f3), un écrêtage du signal de composition des porteuses étant prévu en amont de l'amplificateur (40), ce dernier étant associé à des moyens de linéarisation (36),
**caractérisé en ce qu'**on fait dépendre le seuil d'écrêtage de la somme des puissances (P1 + P2 + P3) de toutes les porteuses modulées transmises et **en ce qu'**on fait dépendre au moins un paramètre de fonctionnement de l'amplificateur de cette somme de puissances afin de maintenir un rendement optimum de l'amplificateur et/ou afin de minimiser la marge de puissance, c'est-à-dire l'écart entre la puissance de saturation et la puissance moyenne d'utilisation.

2. Procédé selon la revendication 1 **caractérisé en ce que** le paramètre de fonctionnement de l'amplificateur est choisi dans le groupe comprenant la tension d'alimentation et l'intensité de polarisation.

3. Procédé selon revendication 1 ou 2 **caractérisé en ce que** le seuil d'écrêtage est déterminé par un élément à gain variable associé à un élément fournissant un rayon d'écrêtage constant.

4. Procédé selon l'une des revendications 1 à 3. **caractérisé en ce qu'**on compense la modification de gain provoquée par la modification du rayon d'écrêtage par une modification de gain en sens inverse de façon, que le produit des deux gains soit sensiblement égal à 1.

5. Procédé selon l'une des revendications précédentes **caractérisé en ce qu'**on fait varier les paramètres de fonctionnement de l'amplificateur à un rythme suffisamment bas pour permettre la mise à jour des paramètres de linéarisation de l'amplificateur.

6. Procédé selon l'une quelconque des revendications précédentes **caractérisé en ce qu'**on fixe le point de fonctionnement de l'amplificateur de façon telle que sa puissance maximale admissible soit légèrement plus élevée que la puissance nécessaire afin de permettre une transmission de puissance supplémentaire demandée rapidement.

7. Procédé selon la revendication 6 **caractérisé en ce que** la marge de puissance supplémentaire de l'amplificateur est de l'ordre de 10 %.

8. Procédé selon l'une quelconque des revendications précédentes **caractérisé en ce que** les signaux sont transmis en mode CDMA et **en ce que**, pour chaque porteuse, la puissance est évaluée sur la durée d'au moins un symbole pendant chaque intervalle de temps.

9. Procédé selon la revendication 8, **caractérisé en ce que** le symbole utilisé pour l'estimation est le symbole le plus long de l'intervalle de temps.

10. Procédé selon la revendication 8 ou 9, **caractérisé en ce que** l'estimation est effectuée au rythme des bits de codage.

11. Procédé selon l'une des revendications précédentes, **caractérisé en ce que** les porteuses se trouvent dans des bandes adjacentes.

12. Application du procédé selon l'une quelconque des revendications précédentes à une station de base d'un système de télécommunication.

13. Application du procédé selon l'une quelconque des revendications 1 à 11 à un terminal de système de télécommunication.

## Claims

1. Method of transmitting telecommunication signals using a power amplifier associated with linearisation means (36) for amplifying simultaneously a plurality of signals modulating different carriers (f1, f2, f3), in which method the composite signal consisting of said carriers is dipped on the upstream side of the amplifier (40),
**characterised in that** the clipping threshold depends on the sum of the powers (P1 + P2 + P3) of all the modulated carriers transmitted and **in that** at feast one operating parameter of the amplifier depends on said sum of powers in order to maintain an optimum efficiency of the amplifier and/or to minimise the power margin, i.e. the difference between the saturation power and the average operating power.

2. Method according to claim 1. **characterised in that** the amplifier operating parameter is chosen from the group comprising the supply voltage and the bias current.

3. Method according to claim 1 or 2, **characterised in that** the clipping threshold is determined by s variable gain component associated with a component providing a constant clipping radius.

4. Method according to any of claims 1 to 3, **characterised in that** the gain modification caused by modifying the clipping radius is compensated by an opposite gain modification such that the product of the two gains is substantially equal to 1.

5. Method according to any preceding claim, **characterised in that** the operating parameters of the amplifier are varied at a sufficiently slow rate to enable updating of linearisation parameters of the amplifier.

6. Method according to any one of the preceding claims, **characterised in that** the operating point of the amplifier is fixed so that its maximum permitted power is slightly greater than the necessary power to enable rapid transmission of demanded additional power.

7. Method according to claim 6, **characterised in that** the additional power margin of the amplifier is of the order of 10%.

8. Method according to any one of the preceding claims, **characterised in that** the signals are transmitted in CDMA mode and **in that** the power for each earner is evaluated over the duration of a symbol in each time slot.

9. Method according to claim 8, **characterised in that** the symbol used for the estimation is the longest symbol in the time slot.

10. Method according to claim 8 or 9, **characterised in that** the estimation is effected at the timing rate of the coding bits.

11. Method according to any preceding claim, **characterised in that** the carriers are in adjacent bands.

12. Application of the method according to any one of the preceding claims to a telecommunication system base station.

13. Application of the method according to any one of claims 1 to 11 to a telecommunication system terminal.

## Patentansprüche

1. Verfahren zur Übertragung von Telekommunikationssignalen anhand eines Leistungsverstärkers, welcher dazu bestimmt ist, simultan verschiedene Mehrträgersignale (f1, f2, f3) zu verstärken, wobei eine dem Verstärker (40) vorgeschaltete Kappung der Wahlsignale der Träger vorgesehen ist, wobei der besagte Verstärker mit Linearisierungsmitteln (36) verbunden ist,
**dadurch gekennzeichnet, dass** man die Kappungsgrenze von der Summe der Leistungen (P1 + P2 + P3) aller übertragenen Mehrträgersignale abhängig macht, und dass man mindestens einen Funktionsparameter des Verstärkers von dieser Summe der Leistungen abhängig macht, um einen optimalen Wirkungsgrad des Verstärkers beizubehalten und/oder die Leistungsreserve, d.h. den Unterschied zwischen der Sättigungsleistung und der durchschnittlichen Benutzungsleistung, zu minimieren.

2. Verfahren nach Anspruch 1, **dadurch gekennzeichnet, dass** der Funktionsparameter des Verstärkers in einer Gruppe gewählt wird, welche die Versorgungsspannung und die Intensität der Polarisierung umfasst.

3. Verfahren nach Anspruch 1 oder 2, **dadurch gekennzeichnet, dass** die Kappungsgrenze durch ein dem Element, welches einen konstanten Kappungsradius bereitstellt, zugeordnetes Element mit variabler Verstärkung bestimmt wird.

4. Verfahren nach einem der Ansprüche 1 bis 3, **dadurch gekennzeichnet, dass** man die durch, die Veränderung des Kappungsradius verursachte Veränderung der Verstärkung durch eine Veränderung der Verstärkung in entgegengesetzter Richtung kompensiert, so dass das Produkt beider Verstärkungen annähernd gleich 1 ist.

5. Verfahren nach einem der vorstehenden Ansprüche, **dadurch gekennzeichnet, dass** die Funktionsparameter des Verstärkers in einem Rhythmus verändert werden, welcher niedrig genug ist, um die Aktualisierung der Linearisierungsparameter des Verstärkers zu ermöglichen.

6. Verfahren nach einem beliebigen der vorstehenden Ansprüche, **dadurch gekennzeichnet, dass** der Arbeitspunkt des Verstärkers derart festgelegt wird, dass dessen maximale Leistungsaufnahme leicht über der erforderlichen Leistung liegt, so dass eine schnelle Übertragung der angeforderten zusätzlichen Leistung ermöglicht wird.

7. Verfahren nach Anspruch 6. **dadurch gekennzeichnet, dass** die zusätzliche Leistungsreserve des Verstärkers einer Größenordnung von 10 % entspricht.

8. Verfahren nach einem beliebigen der vorstehenden Ansprüche, **dadurch gekennzeichnet, dass** die Signale im CDMA-Modus übertragen werden, und dass für jeden Träger die Leistung auf der Dauer von mindestens einem Symbol während eines jeden Zeitschlitzes bewertet wird.

9. Verfahren nach Anspruch 8, **dadurch gekennzeichnet, dass** das für die Bewertung verwendete Symbol das längste Symbol des Zeitschlitzes ist.

10. Verfahren nach Anspruch 8 oder 9, **dadurch gekennzeichnet, dass** die Bewertung im Rhythmus der Codierungsbits erfolgt.

11. Verfahren nach einem der vorstehenden Ansprüche, **dadurch gekennzeichnet, dass** sich die Träger in benachbarten Bändern befinden.

12. Anwendung des Verfahrens nach einem beliebigen der vorstehenden Ansprüche auf eine Basisstation eines Telekommunikationssystems.

13. Anwendung des Verfahrens nach einem beliebigen der vorstehenden Ansprüche 1 bis 11 auf Endgeräte des Telekommunikationssystems.
